# FASCICULE DE BREVET EUROPEEN

(11) **EP 4 513 268 B1**
(45) Date de publication et mention de la délivrance du brevet: **01.04.2026**
(21) Numéro de dépôt: 24194193.9
(22) Date de dépôt: 12.08.2024
(51) Int. Cl.: G03F 7/00, H01L 21/306, H01L 21/311, H01L 21/3213

(54) **PROCEDE DE REALISATION DE MOTIFS SUR UN SUBSTRAT**
VERFAHREN ZUR HERSTELLUNG VON MUSTERN AUF EINEM SUBSTRAT
METHOD FOR PRODUCING PATTERNS ON A SUBSTRATE

(30) Priorité: 18.08.2023 FR 2308799
(43) Date de publication de la demande: 26.02.2025
(73) Titulaire: Commissariat à l'Energie Atomique et aux Energies Alternatives, 75015 Paris (FR)
(72) Inventeur: MONTMEAT, Pierre, 38054 GRENOBLE CEDEX 09 (FR); FOURNEL, Franck, 38054 GRENOBLE CEDEX 09 (FR)
(74) Mandataire: Cabinet Beaumont

(56) Documents cités:
- US-A1- 2011 017 705
- US-A1- 2017 372 917
- PARK SEONG-JUN ET AL: "Fabrication of graphite grids via stencil lithography for highly sensitive motion sensors", CARBON, ELSEVIER OXFORD, GB, vol. 96, 25 September 2015 (2015-09-25), pages 491 - 496, XP029314392, ISSN: 0008-6223, DOI: 10.1016/J.CARBON.2015.09.080

## Description

### Domaine technique

La présente description concerne de façon générale le domaine de la microélectronique et plus particulièrement la réalisation de motifs sur un substrat en vue de la fabrication de composants microélectroniques.

### Technique antérieure

L'élaboration de composants microélectroniques nécessite la réalisation de motifs sur un substrat par photolithographie.

La photolithographie est réalisée au travers de différentes étapes mettant en œuvre une résine : étalement de la résine sur un substrat, insolation de la résine au moyen d'un masque, développement, gravure puis retrait de la résine (ou « stripping »). L'étape de retrait (ou nettoyage de la résine) est une étape complexe car elle nécessite de trouver un agent de nettoyage suffisamment agressif pour nettoyer parfaitement la résine tout en préservant l'intégrité des différentes surfaces.

Pour chaque substrat sur lequel des composants microélectroniques doivent être réalisés, ces différentes étapes sont répétées. Or, ces étapes sont, non seulement, longues à mettre en œuvre, mais, en plus, elles engendrent des coûts importants, dus notamment à l'utilisation des résines, des solvants et des solutions de nettoyage utilisés.

US 2017/372917 A1 et US 2011/017705 A1 divulguent des procédés de structuration utilisant des masques de contact qui ne nécessitent pas l'utilisation de résine.

### Résumé de l'invention

Il existe un besoin d'obtenir un procédé qui permet de réaliser des motifs sur un substrat tout en limitant les coûts et la durée du procédé par rapport aux procédés actuels.

Ce but est atteint par un procédé de structuration d'un substrat d'intérêt comprenant les étapes suivantes :
a) coller un substrat-poignée sur un substrat d'intérêt, le substrat-poignée comprenant une base et des éléments en relief recouvrant la base, le substrat d'intérêt comprenant un substrat support recouvert par une couche mince, la couche mince comprenant un matériau sensible à un agent de gravure, moyennant quoi la couche mince comprend des premières zones non recouvertes par les éléments en relief et des deuxièmes zones recouvertes par les éléments en relief,
b) réaliser une gravure avec l'agent de gravure, par voie humide ou gazeuse, pour retirer le matériau sensible à l'agent de gravure présent dans les premières zones, les deuxièmes zones étant protégées lors de la gravure, moyennant quoi la couche mince est structurée sous la forme de motifs en relief,
c) séparer le substrat-poignée du substrat d'intérêt.

Un mode de réalisation prévoit que la couche mince comprend un matériau de base, de préférence un oxyde, et plus particulièrement un oxyde de silicium, dans lequel sont disposés des plots, de préférence des plots métalliques, et encore plus préférentiellement des plots en cuivre.

Un mode de réalisation prévoit que le matériau sensible à l'agent de gravure est le matériau de base.

Un autre mode de réalisation prévoit que le matériau sensible à l'agent de gravure correspond aux plots.

Un mode de réalisation particulier prévoit que la couche mince comprend des barrières, de préférence des barrières métalliques, et plus particulièrement des barrières en cuivre, formant une protection latérale tout autour des deuxièmes zones.

Un autre mode de réalisation prévoit que, lors de l'étape de gravure, les barrières et les plots sont gravés.

Un autre mode de réalisation prévoit que le procédé comprend une étape additionnelle entre l'étape b) et l'étape c) au cours de laquelle les barrières et/ou les plots sont gravés.

Un autre mode de réalisation prévoit que le procédé comprend une étape ultérieure au cours de laquelle le substrat-poignée est utilisé pour structurer un autre substrat d'intérêt.

Un autre mode de réalisation prévoit que, avant l'étape de collage, le procédé comprend une étape au cours de laquelle, le substrat-poignée est recouvert par une couche de protection à l'agent de gravure du matériau sensible. La couche de protection peut être une couche d'oxyde ou une couche hydrophobe, la couche hydrophobe pouvant être formée d'un ou plusieurs composés choisis parmi les silanes, notamment les chlorosilanes, et les polymères comprenant un ou plusieurs halogènes, de préférence les polymères fluorés.

Un autre mode de réalisation prévoit que le procédé comprend, avant l'étape a), une étape au cours de laquelle le substrat-poignée est fabriqué en formant localement une résine sur un substrat, en gravant le substrat et en retirant la résine.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D et 1E représentent, de manière schématique, différents étapes d'un procédé de structuration d'un substrat selon un mode de réalisation particulier de l'invention ;
les figures 2A, 2B et 2C et 2D représentent, de manière schématique, différents étapes d'un procédé pour fabriquer un substrat-poignée selon un mode de réalisation particulier de l'invention ;
la figure 3 représente, de manière schématique et en coupe, un substrat-poignée recouvert par une couche de protection selon un mode de réalisation particulier de l'invention ;
les figures 4A, 4B, 4C, 4D et 4E représentent, de manière schématique, différents étapes d'un procédé pour rendre hydrophobe un substrat-poignée selon un mode de réalisation particulier de l'invention ;
les figures 5A, 5B et 5C représentent, de manière schématique, plusieurs configurations après collage d'un substrat-poignée avec un substrat d'intérêt, selon différents modes de réalisation particuliers de l'invention ;
les figures 6A, 6B, 6C et 6D représentent, de manière schématique, différentes étapes d'un procédé de structuration d'un substrat d'intérêt selon un autre mode de réalisation particulier de l'invention ; et
les figures 7A et 7B représentent de manière schématique différentes étapes d'un procédé de structuration d'un substrat d'intérêt selon un autre mode de réalisation particulier, le substrat étant représenté en vue de dessus et les pointillés représentant la position d'un élément en relief du substrat-poignée ;
les figures 7C et 7D représentent de manière schématique et en coupe le substrat représenté sur les figures 7A et 7B respectivement ;
les figures 8A et 8B représentent de manière schématique différentes étapes d'un procédé de structuration d'un substrat d'intérêt selon un autre mode de réalisation particulier, le substrat étant représenté en vue de dessus et les pointillés représentant la position d'un élément en relief du substrat-poignée ;
les figures 8C et 8D représentent de manière schématique et en coupe le substrat représenté sur les figures 8A et 8B respectivement ;
les figures 9A, 9B et 9C représentent de manière schématique différentes étapes d'un procédé de structuration d'un substrat d'intérêt selon un autre mode de réalisation particulier, le substrat étant représenté en vue de dessus et les pointillés représentant la position d'un élément en relief du substrat-poignée.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures dans une position normale d'utilisation.

Sauf précision contraire, les expressions "environ", "approximativement", "sensiblement", et "de l'ordre de" signifient à 10 % près, de préférence à 5 % près.

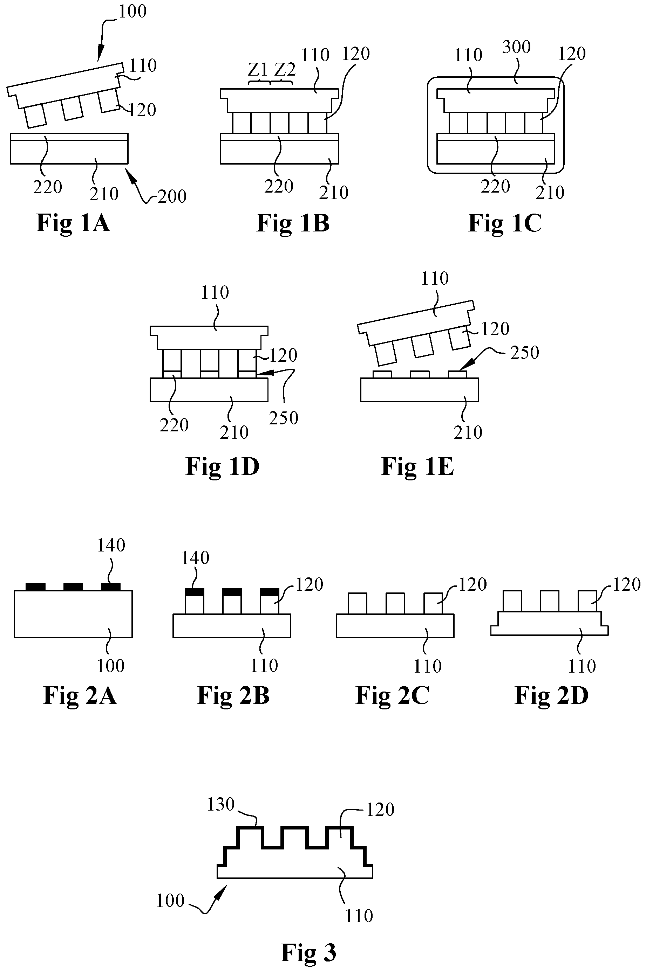

Nous allons maintenant décrire plus en détail le procédé de réalisation de motifs sur un substrat en faisant tout d'abord référence aux figures 1A à 1E.

Le procédé comprend les étapes suivantes :
a) coller un substrat-poignée 100 avec un substrat d'intérêt 200, le substrat-poignée 100 comprenant une base 110 et des éléments en relief 120 recouvrant la base 110, le substrat d'intérêt 200 comprenant un substrat support 210 recouvert par une couche mince 220, la couche mince 220 comprenant un matériau sensible à un agent de gravure, moyennant quoi des premières zones Z1 de la couche mince 220 ne sont pas recouvertes par les éléments en relief 120 du substrat-poignée 100 et des deuxièmes zones Z2 de la couche mince 220 sont recouvertes par les éléments en relief 120 du substrat-poignée 100 (figures 1A et 1B),
b) réaliser une gravure, par voie humide ou par voie gazeuse, avec l'agent de gravure adapté au matériau sensible à l'agent de gravure, moyennant quoi le matériau sensible présent dans les premières zones Z1 de la couche mince 220 est retiré, les éléments en relief 120 du substrat-poignée 100 protégeant les deuxièmes zones Z2 de la couche mince 220 lors de la gravure, et on obtient une couche mince 220 structurée sous la forme de motifs 250 en relief (figures 1C et 1D),
c) séparer le substrat-poignée 100 du substrat d'intérêt 200, moyennant quoi on obtient un substrat d'intérêt 200 structuré comprenant un substrat support 210 recouvert par des motifs 250 en relief (figure 1E).

Le substrat-poignée 100 forme un masque dur. Il permet de former des motifs 250 sur le substrat d'intérêt sans mettre en œuvre d'étapes de photolithographies. Le procédé est ainsi simple et rapide à mettre en œuvre.

De plus, avec un seul et même substrat-poignée 100, il est possible de former des motifs sur plusieurs substrats (plaquettes). Le substrat-poignée est réutilisable, ce qui réduit d'autant plus les coûts de procédé.

Préalablement à l'étape a), il est possible de réaliser un ou plusieurs pré-traitements sur la surface du substrat-poignée 100 et/ou sur la surface du substrat d'intérêt 200 de façon à les rendre compatible avec un collage direct.

Le prétraitement peut être choisi parmi les pré-traitements suivants : recuit thermique, plasma, polissage et nettoyage humide.

A titre d'exemple, il est possible de former une couche d'oxyde à la surface du substrat-poignée 100 et/ou de réaliser une étape de polissage sur le substrat-poignée 100 et/ou sur le substrat d'intérêt 200 pour obtenir une rugosité compatible avec un collage direct (typiquement une rugosité inférieure à 0,5 nm RMS). Il est possible de mettre en œuvre des procédés qui combinent, par exemple, un plasma et une solution aqueuse, notamment un plasma oxygène suivi d'un nettoyage humide CARO (H₂SO₄, H₂O₂ en proportion 5 :1) associé avec SC1 (H₂O, NH₃, H₂O₂ en proportion 5 :1 :1 à 70°C).

Lors de l'étape a), le substrat-poignée 100 et le substrat d'intérêt 200 sont mis en contact pour être collés.

Les deux substrats 100, 200 peuvent être assemblés par collage direct. L'utilisation de marques sur les substrats 100, 200 peut faciliter leur alignement. Une précision d'environ 100nm peut être atteinte. Il est également possible de les aligner, sans avoir recours aux marques, en utilisant les bords des substrats ainsi que leur encoche (ou 'notch'). La précision est moindre (+/- 50µm) mais suffisante pour certaines applications.

Le collage direct peut être réalisé à la pression atmosphérique (soit 1013,25 hPa) ou sous vide. L'assemblage n'a pas forcément besoin d'être consolidé par un traitement thermique. Néanmoins, un recuit, à une température de préférence inférieure à 200°C, peut être avantageusement réalisé.

Comme représenté sur les figures annexées, le substrat-poignée 100 comprend une base 110 et des éléments 120 en relief (piliers ou colonnes). La surface des éléments 120 peut être de différentes formes. Elle peut être carrée, rectangulaire ou encore circulaire. Les éléments 120 en relief ont, par exemple, une hauteur comprise entre 1 µm et 200 µm ou plus spécifiquement entre 10 µm et 100 µm. Ces éléments 120 sont, de préférence, espacés de plus de 10 µm voire de plus de 50 µm afin de permettre l'infiltration de l'agent de gravure (gazeux ou liquide) par capillarité au sein du réseau formé par les éléments 120 en relief.

La base 110 et les éléments en relief peuvent être en des matériaux différents. De préférence, ils sont en un même matériau.

Le substrat-poignée 100 est, de préférence, obtenu à partir d'un substrat massif. Il peut s'agir d'un substrat en métal ou en matériau semi-conducteur par exemple.

Notamment, les éléments 120 en relief du substrat-poignée 100 peuvent être réalisés au moyen d'une étape de photolithographie, par exemple au moyen des sous-étapes suivantes, représentées sur les figures 2A, 2B, 2C et 2D :
- déposer localement une résine 140 sur un substrat (figure 2A),
- graver les parties du substrat non recouvertes par la résine 140 pour former des éléments 120 en relief dans le substrat (figure 2B),
- retirer la résine 140 (figure 2C),
- éventuellement, détourer le substrat (figure 2D).

Le détourage du bord de plaque permet d'éviter un éventuel contact en bord entre le substrat-poignée 100 et le substrat d'intérêt 200.

Le détourage peut être réalisé par exemple par photolithographie/gravure, ou encore par détourage mécanique au moyen d'une scie diamantée. La largeur du détourage est comprise, par exemple, entre 1 et 5 mm et/ou sa profondeur comprise, par exemple, entre 100 et 250 µm.

Lors de l'étape de gravure, les motifs 250 formés sur le substrat d'intérêt 200 par la gravure verticale peuvent subir également une gravure horizontale, ce qui modifie ainsi leurs dimensions latérales. Cet effet de gravure latérale pourra être pris en compte dans le dimensionnement des éléments 120 en relief pour pouvoir obtenir des motifs 250 ayant les dimensions souhaitées.

De plus, lors de l'étape b), il est possible que l'agent de gravure grave non seulement le matériau sensible à l'agent de gravure, mais également les flancs des éléments 120 en relief du substrat-poignée 100. Par exemple, pour une gravure du substrat d'intérêt 200 de quelques dizaines de micromètres, il est possible que la dimension latérale des éléments 120 du substrat-poignée 100 soit également réduite de quelques dizaines de micromètres. Si ce substrat-poignée 100 est de nouveau utilisé, les motifs 250 gravés sur le nouveau substrat d'intérêt auront donc une dimension inférieure à celle obtenue lors de l'utilisation précédente. Pour certaines applications, notamment pour des applications nécessitant des motifs 250 assez grands (typiquement des motifs millimétriques ou centimétriques), une tolérance sur les variations de dimensions de quelques dizaines de micromètres est acceptable. Pour d'autres applications, notamment pour des applications nécessitant des motifs de plus faible dimension, par exemple de dimension inférieure au millimètre, il est souhaitable que les dimensions des éléments 120 en relief du substrat poignée 100 soit identiques ou sensiblement identiques d'un substrat d'intérêt 200 à un autre substrat d'intérêt.

Afin d'éviter toute variation de dimension due à la gravure, il est possible, par exemple, de recouvrir les éléments 120 en relief par une couche de protection 130, 135. Cette couche de protection peut être en un matériau hydrophobe qui va empêcher l'action des solutions aqueuses de gravure ou en un matériau inerte vis-à-vis de l'agent de gravure (ou tout au moins ayant une faible vitesse de gravure par l'agent de gravure). On peut aussi choisir un substrat-poignée constitué d'un matériau inerte vis-à-vis de l'agent de gravure (ou tout au moins ayant une faible vitesse de gravure par l'agent de gravure).

Selon une première variante avantageuse, la couche de protection est une couche d'oxyde 135. La couche d'oxyde est inerte vis-à-vis de l'agent de gravure. La couche d'oxyde 135 peut voir une épaisseur comprise entre 20 nm et 5000 nm. La couche peut aussi être appelée film. Il peut s'agir d'un oxyde thermique, d'un oxyde natif ou d'un oxyde déposé, par exemple par dépôt chimique d'alcoxyde de silicium tel que l'orthosilicate de tétraéthyle (TEOS) ou de silane en phase vapeur assisté ou non par un plasma.

La couche d'oxyde 135 peut recouvrir entièrement les éléments en relief 120 du substrat 100 (figure 3). Elle ne gêne pas le collage.

Notamment, dans le cas d'un substrat-poignée 100 en silicium, le film d'oxyde est présent sur l'ensemble du substrat-poignée 110.

Avantageusement, on utilisera un substrat-poignée 100 recouvert d'une couche d'oxyde de silicium pour former des motifs 250 sur un substrat d'intérêt 200 en silicium ou en un métal comme le cuivre. L'oxyde de silicium étant peu sensible aux agents de gravure du silicium (comme KOH, TMAH ou un mélange HF/HNO₃) ou aux agents de gravure de métaux comme le cuivre (par exemple des solutions formées d'un mélange H₂SO₄/H₂O₂/H₂O), le substrat-poignée 100 ne sera pas gravé et la géométrie ainsi que les dimensions des éléments en relief 120 seront conservées.

Selon une deuxième variante avantageuse, le substrat-poignée 100 peut être recouvert partiellement ou totalement par une couche hydrophobe 130. La couche hydrophobe 130 agit comme une barrière à l'agent aqueux de gravure. La couche hydrophobe 130 peut être inorganique ou organique. La couche peut aussi être appelée film.

Le choix de la couche hydrophobe 130 dépendra du substrat-poignée 100, du substrat d'intérêt 200 et de la solution de gravure 300.

La couche hydrophobe 130 a, par exemple, une épaisseur comprise entre 2 et 1000 nm.

Il peut s'agir d'une couche hydrophobe 130 obtenue à partir d'un polymère ou d'un silyle (aussi appelés organo-silylés).

Le composé hydrophobe choisi comprend, de préférence, un ou plusieurs groupes halogènes, notamment des groupes fluor ou chlore. De préférence, le composé hydrophobe comprend une chaine carbonée d'au moins 5 atomes de carbone.

Le silane peut être un chlorosilane comme l'octadécyltrichlorosilane (OTS = CH₃(-CH₂)₁₇-SiCl₃) commercialisé par la société Sigma Aldrich.

Les polymères peuvent être des polymères fluorés comme par exemple le polymère Novec^{™} 1720 EGC commercialisé par la société 3M^{™}, l'Optool commercialisé par la société DAIKIN et le polymère Novec^{™} 2202 EGC commercialisé par la société 3M^{™}. Le composé hydrophobe peut être choisi parmi les chlorosilanes comme le perfluorodecyltrichlorosilane (FDTS = Cl₃Si(CH₂)₂(CF₂)₇CF₃) commercialisé par la société Sigma-Aldrich, le perfluorodecyldimethylchlorosilane (FDDMCS = CF₃(CF₂)₇(CH₂)₂(CH₃)₂SiCl) commercialisé par la société Sigma-Aldrich.

De préférence, la couche hydrophobe 130 est déposée par voie liquide.

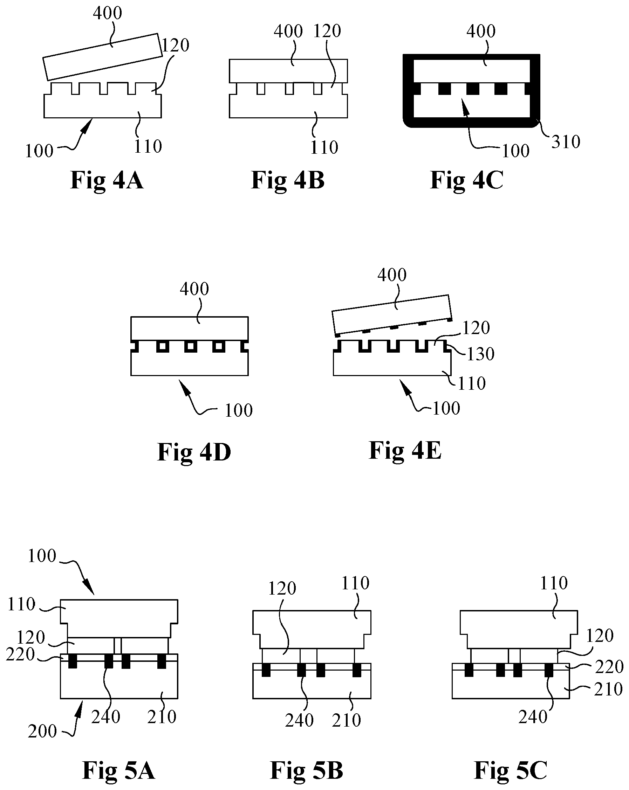

Par exemple, en faisant référence aux figures 4A à 4E, la couche hydrophobe 130 peut être déposée selon les étapes suivantes :
- coller le substrat-poignée 100 avec un substrat temporaire 400 (figures 4A et 4B),
- mettre en contact l'ensemble obtenu avec une solution 310 contenant le composé hydrophobe, par exemple par immersion (figure 4C),
- après un éventuel rinçage, sécher le substrat-poignée 100, moyennant quoi le substrat-poignée 100 est recouvert localement voire totalement par une couche hydrophobe 130 (figure 4D),
- séparer le substrat-poignée 100 du substrat temporaire 400 (figure 4E).

Les parois latérales (flancs) des éléments 120 en relief du substrat-poignée 100 sont recouverts d'un film hydrophobe 130. L'épaisseur du film hydrophobe 130 est, par exemple, de l'ordre d'une dizaine de nanomètres. Les parties du substrat-poignée 100 non exposées au composé hydrophobe sont compatibles avec un procédé de collage direct.

Le substrat temporaire 400 peut être recyclé, par exemple, en mettant en œuvre un traitement plasma oxygène suivi d'un nettoyage par voie humide.

Le film hydrophobe 130 va rendre impossible le contact entre la surface du substrat-poignée 100 et la solution de gravure 300. Seul, le matériau sensible à l'agent de gravure du substrat d'intérêt 100 à structurer est gravé, tout en préservant la morphologie des éléments 120 en relief du substrat-poignée 100.

Selon un autre mode de réalisation avantageux, on utilisera un substrat-poignée 100 et un substrat d'intérêt 200 dont les vitesses de gravure sont considérablement différentes en présence d'un agent de gravure. De manière très avantageuse, la solution de gravure 300 ne grave pas ou peu le substrat-poignée.

Avantageusement, le substrat-poignée 100 et la couche mince 220 à structurer sont en des matériaux différents. Par exemple, il est possible de choisir des matériaux différents parmi un métal, un matériau semi-conducteur, un oxyde, etc.

Selon une autre variante avantageuse, le matériau formant le substrat-poignée 100 peut avoir une orientation cristalline différente de celle de la couche mince 120 à structurer du substrat d'intérêt 100. Ainsi, même si les matériaux sont identiques, leurs vitesses de gravure dans une solution donnée seront différentes. On choisira l'orientation cristalline de manière à ce que la vitesse de gravure du substrat-poignée 100 dans la solution de gravure soit inférieure à la vitesse de gravure de la couche 220 dans la solution de gravure 300.

Par exemple, avec le silicium, il est possible de bénéficier de certaines propriétés de gravure anisotrope pour obtenir cet effet. Par exemple, les plans <111> du silicium ont une vitesse de gravure par le TMAH, le TEAH ou le KOH bien moindre que la surface <001> exposée. Ceci permet donc de limiter grandement la gravure latérale en faisant apparaitre des plans <111>.

Le substrat d'intérêt 200 comprend le substrat support 210 recouvert par la couche mince 220 comprenant au moins un matériau sensible à un agent de gravure.

Le substrat d'intérêt 200 peut être un substrat SOI ('Silicon on Insulator'), c'est-à-dire comprenant un substrat support 210 recouvert par une fine couche d'oxyde enterré et une couche de silicium 220. La fine couche d'oxyde peut jouer le rôle de couche d'arrêt de gravure (gravure verticale).

Alternativement, il peut s'agir d'un substrat massif 210 en matériau semiconducteur (silicium par exemple) recouvert d'une couche diélectrique 220, en particulier une couche d'oxyde (oxyde de silicium notamment).

Au sein de la couche mince 220, des éléments 240 peuvent être disposées. Ces éléments 240 forment des parois verticales dans la couche mince 220. Ces éléments 240 entourent les deuxièmes zones Z2. Ce sont des barrières de protection 240 permettant d'arrêter la sur-gravure latérale, qui peut parfois accompagner la gravure verticale du matériau gravé. La largeur de cette barrière sera choisie de manière à être suffisamment importante pour arrêter la sur-gravure. Les éléments 240 peuvent avoir des formes identiques ou différentes. Ils sont, bien entendu, en un matériau différent du matériau sensible à l'agent de gravure.

Le positionnement des éléments 240 est, de préférence, choisi de sorte que, lors du collage du substrat-poignée 100 et du substrat d'intérêt 200, les éléments 240 soient positionnés totalement ou partiellement sous les éléments en relief du substrat poignée 100. Les deuxièmes zones Z2 à protéger ne sont ainsi pas exposées à l'agent de gravure.

Une tolérance latérale est également envisageable. Par exemple, un des éléments en relief 120 peut dépasser de l'emplacement souhaité du motif 250 ou être décalé par rapport à l'emplacement souhaité du motif 250.

Les figures 5A, 5B et 5C montrent différentes configurations possibles.

L'élément en relief 120 peut, par exemple, présenter une surface plus importante que la surface à protéger positionnée entre les barrières de protection 240 (figure 5A) ou un désalignement peut exister entre les éléments en relief 120 et les barrières de protection 240, les barrières de protection 240 dépassant ainsi de l'élément en relief 120 (figures 5B et 5C).

Néanmoins, dans ces différentes configurations, la gravure est effective et s'arrête sur la barrière de protection 240. Il est bien évident que ce cas présente des limites et que la largeur de sous-gravure est choisie de manière à ne pas être trop importante, par exemple quelques dizaines de microns est acceptable. De préférence, on ne dépassera pas 1mm et, plus spécifiquement, on ne dépassera pas 500µm.

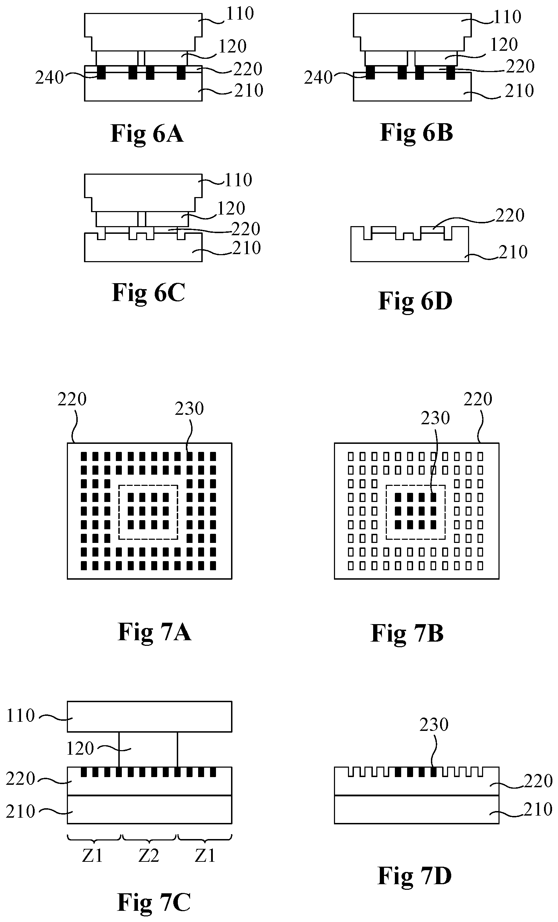

Lorsque la couche mince 220 comprend des barrières de protection 240, le procédé peut comprendre entre l'étape b) et l'étape c) une étape additionnelle au cours de laquelle les barrières de protection 240 sont retirées. Le procédé comprend alors les étapes suivantes :
- coller le substrat-poignée 100 et le substrat d'intérêt 200 (figure 6A),
- graver le matériau sensible à la gravure présent dans les premières zones Z1 de la couche mince 220 non protégée par les éléments en relief 120, avec un agent de gravure adapté (figure 6B),
- graver les barrières de protection 240 avec un autre agent de gravure (figure 6C),
- séparer le substrat-poignée 100 du substrat d'intérêt 200 (figure 6D).

Pour certaines applications, la couche mince 220 peut comprendre un matériau de base (oxyde notamment) et des plots 230, notamment des plots métalliques (figures 7A à 7D, 8A à 8D et 9A à 9C).

Dans le cas où le matériau sensible à la gravure correspond aux plots 230, le matériau de base n'est pas gravé, et on obtient une couche mince 220 comprenant une pluralité de trous (borgnes ou traversant la couche mince 220) et des motifs 250 en relief (figures 7A à 7D). Les trous sont obtenus par retrait des plots 230. Les motifs en relief 250 correspondent aux deuxièmes parties Z2 de la couche mince 220 qui était protégée par les éléments en relief 120 du substrat-poignée 100.

Selon un mode de réalisation particulier, la couche mince 120 comprend un matériau de base, des barrières de protection 240 et des plots 230.

Les plots 230 peuvent être entourés par une couche protectrice pour les protéger lors de l'étape de gravure. Par exemple, des couches de Ti et TiN ou de Ta et TaN peuvent entourer des plots 230 en cuivre. Des types de gravure spécifiques peuvent alors être employés pour ces matériaux.

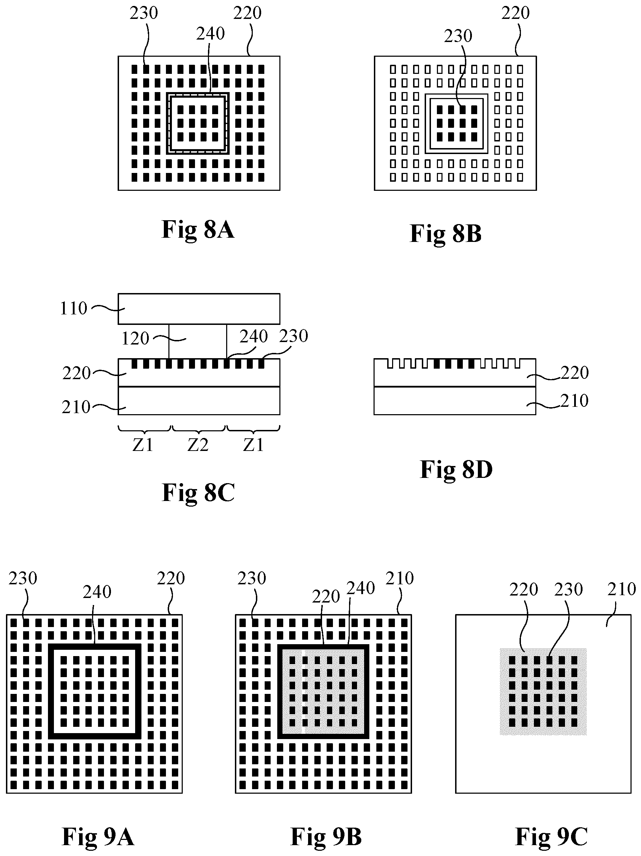

Selon une première variante de réalisation, les barrières de protection du matériau de base 240 et les plots 230 sont sensibles au même agent de gravure. Les barrières de protection 240 sont, de préférence, en un même matériau que les plots 230. Encore plus préférentiellement, il s'agit d'un métal, tel que le cuivre. Avantageusement, le matériau de base est un oxyde, par exemple un oxyde de silicium. Les barrières de protection 240 et les plots 230 peuvent ainsi être retirés lors d'une unique étape de gravure (figures 8A à 8D). On obtient ainsi une couche mince 220 comprenant une pluralité de trous (borgnes ou traversant la couche mince 220) au niveau des premières zones Z1. Les deuxièmes zones Z2 de la couche mince 220 en regard des éléments en relief 120 sont préservées lors de l'étape de gravure.

Selon une deuxième variante de réalisation, le matériau de base est sensible à l'agent de gravure. Les barrières de protection 240 et les plots 230 ne sont pas sensibles à l'agent de gravure (figure 9A). Les barrières de protection 240 et les plots 230 peuvent être en un même matériau ou en des matériaux différents. Par exemple, les barrières de protection 240 et les plots 230 sont en métal, de préférence en cuivre. Le matériau de base est, par exemple, un oxyde, et notamment un oxyde de silicium. Lors de l'étape de gravure, le matériau de base présent dans les premières zones Z1 est gravé. Les barrières de protection 240 et les plots métalliques 230 non sensibles à l'élément de gravure sont préservés lors de l'étape de gravure (figure 9B). On obtient une structure comprenant des motifs en relief 250 entourés de barrières de protection 240. Les motifs en relief 250 comprennent le matériau de base dans lequel sont dispersés les plots 230. Les motifs 250 peuvent être entourés par les barrières de protection 240. Entre les motifs 250, le substrat support 210 est recouvert par les plots métalliques 230 (figure 9B).

Il est possible de réaliser une étape de gravure supplémentaire (ou plusieurs étapes de gravure supplémentaires) pour retirer les plots métalliques 230 et/ou les barrières de protection 240 (figure 9C).

Les barrières 240 métalliques et/ou les plots métalliques 230 peuvent être inséré dans la couche d'oxyde, par exemple avec un procédé de type de Damascène.

En particulier, il est possible de choisir des barrières 240 métalliques et/ou des plots métalliques 230 en cuivre insérés dans une couche d'oxyde de silicium.

Les barrières 240 métalliques et/ou les plots métalliques 230 peuvent être formés, par exemple, par dépôt physique en phase vapeur (ou PVD pour « Physical Vapor Deposition ») et/ou par dépôt électrochimique (ECD).

De préférence, pour des former des éléments 230 en cuivre par ECD, on déposera préalablement des couches de Ti, TiN et Cu par PVD. Le dépôt par ECD permet de former des éléments de plus fortes épaisseurs que la PVD. Il est également possible de remplacer les couches de Ti et TiN par des couches de Ta et TaN. Les couches de Ti / TiN ou de Ta / TaN jouent le rôle de barrière à la diffusion du cuivre dans le silicium.

A l'issue de l'étape b) ou de l'étape de gravure additionnelle, l'assemblage peut être rincé par immersion et séché. Le séchage peut être réalisé par centrifugation.

Le substrat d'intérêt obtenu 200 comprend un substrat support recouvert par les motifs 250 en relief. L'épaisseur des motifs dépend de l'application visée. Les motifs peuvent être formé d'un matériau de base (figure 6D) ou d'un matériau de base dans lequel sont dispersés des plots 230 (figure 7D). Un élément 240 peut entourer les motifs (figure 9B).

En dehors des motifs 250, plusieurs variantes de réalisation sont possibles, et notamment :
- le substrat support 210 peut être recouvert d'une couche mince 220 présentant des trous borgnes (figure 7B) ou des trous traversants ladite couche 220,
- des plots 230 peuvent être positionnés sur le substrat support 210 (figure 9B),
- le substrat support 210 peut présenter une surface libre (i.e. en dehors des motifs, aucun élément ne recouvre le substrat support 210) (figure 9C).

Lors de l'étape c), on démonte l'assemblage en insérant par exemple un coin entre les deux substrats 100, 200.

Le substrat-poignée 100 peut être utilisé dans un nouveau cycle de collage/gravure. Un nettoyage est, avantageusement, réalisé entre chaque utilisation.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

### Exemples illustratifs et non limitatifs de différents modes de réalisation

Dans les exemples suivants, les substrats sont réalisés à partir de plaquettes de silicium de 200 mm de diamètre.

### Exemple 1

Une plaquette de silicium (substrat poignée 100) subit une oxydation de façon à obtenir en surface un film de 100 nm d'oxyde de silicium. Un procédé de photolithographie/gravure permet de former des plots d'oxyde de silicium de 10 x 10 mm² et d'une épaisseur de 100 µm (100 nm de SiO₂ et 99,9 µm de silicium). On réalise un détourage du bord de la plaquette 100 à la scie diamantée d'une largeur de 3 mm et d'une profondeur de 200 La surface d'oxyde de la plaquette 100 est nettoyée par un plasma O₂ suivi d'un nettoyage par voie humide CARO, SC1 de façon à la rendre compatible avec un procédé de collage direct.

Une plaquette SOI (substrat d'intérêt 200) qui présente un substrat support 220 recouvert par un film de silicium 220 de 205 nm et une couche d'oxyde enterré de 400 nm subit un nettoyage de façon par voie humide CARO/SC1 de façon à la rendre compatible avec un procédé de collage direct.

On colle directement les deux substrats 100, 200 l'un avec l'autre. De façon à éliminer la couche d'oxyde natif du silicium, l'assemblage est immergé pendant 10 s dans une solution 300 de HF à 1%, puis rincée dans de l'eau déionisée. On réalise ensuite une deuxième gravure de 3 min à 70°C dans une solution aqueuse de TMAH à 5 % massique. L'assemblage est ensuite rincé par immersion dans l'eau puis séchée par centrifugation.

On retire le substrat-poignée 100 en insérant un coin dans la structure.

On obtient une plaque d'intérêt 200 comprenant un substrat support en silicium sur lequel sont disposés des plots 250 de silicium de 10 x 10 mm² d'une épaisseur de 205 nm.

### Exemple 2

Une plaquette de silicium (substrat poignée 100) est réalisée comme décrit dans l'exemple 1. Elle présente des éléments en relief 120 (plots rectangulaires) de 10 x 5mm² et d'une épaisseur de 15 µm.

On prépare une plaque de silicium (substrat temporaire 400) de façon à la rendre compatible avec un collage direct. On colle directement le substrat temporaire 400 et le substrat poignée 100. L'assemblage est immergé dans une solution 310 d'OTS (octadécyltrichlorosilane) dans l'isooctane puis rincé dans l'isooctane. Puis on démonte le substrat temporaire 400. La plaquette de silicium 100 présente des sites de collages sous forme de plots 120 rectangulaires de 15 µm de hauteur dont l'environnement y compris les flancs est recouvert d'un film hydrophobe 130.

Une plaquette SOI (substrat d'intérêt 200) qui comprend un substrat support 210 recouvert par un film de silicium 220 de 205 nm et une couche d'oxyde enterré de 400 nm subit un nettoyage de façon par voie humide CARO/SC1 de façon à la rendre compatible avec un procédé de collage direct.

On colle directement le substrat d'intérêt 200 et le substrat poignée 100. De façon à éliminer la couche d'oxyde natif du silicium, l'assemblage est immergé pendant 10 s dans une solution 300 de HF à 1%, puis rincée dans de l'eau DI. On réalise ensuite une deuxième gravure de 3 min à 70°C dans une solution aqueuse de TMAH à 5 % massique destinée à graver le silicium. La couche d'oxyde enterré du substrat d'intérêt permet l'arrêt de la gravure. L'assemblage est ensuite rincé par immersion dans l'eau puis séchée par centrifugation.

On démonte le substrat poignée 100 en insérant un coin dans la structure. Le film hydrophobe 130 a permis de protéger de la gravure le silicium formant les éléments en relief 120 du substrat 100 dont les dimensions n'ont pas été altérée.

On obtient une plaque d'intérêt 200 comprenant un substrat support en silicium sur lequel sont disposés des motifs 250 rectangulaires de silicium de 10 x 5 mm² d'une épaisseur de 205 nm.

### Exemple 3

On réalise une photolithographie / gravure sur une plaque de silicium (substrat poignée 100) de façon à former des éléments 120 cylindriques de 10 mm de diamètre et d'épaisseur 60 On réalise un détourage du bord du substrat poignée 100 à la scie diamantée : d'une largeur de 5 mm et d'une profondeur de 200 Cette plaque est oxydée de façon à former un film d'oxyde de 400 nm en surface.

Une plaquette SOI (substrat d'intérêt 200) comprend un substrat support 210 recouvert par un film 220 de silicium de 205 nm et une couche d'oxyde enterré de 400 nm. Le substrat d'intérêt 200 subit un nettoyage par voie humide CARO/SC1 de façon à la rendre compatible avec un procédé de collage direct. Ce substrat est immergé pendant 10 s dans une solution de gravure 300 (HF à 1%), puis rincé dans de l'eau DI.

On colle directement les deux substrats 100, 200. L'assemblage est immergé pendant 3 min à 70°C dans une solution aqueuse de TMAH à 5 % massique destinée à graver le silicium. La couche d'oxyde enterré du substrat d'intérêt 200 permet l'arrêt de la gravure. L'assemblage est ensuite rincé par immersion dans l'eau puis séchée par centrifugation.

On démonte la plaque (substrat poignée 100) en insérant un coin dans la structure. Le film d'oxyde de 400 nm présent à la surface de ce substrat 100 a permis de protéger de la gravure silicium les éléments en relief 120 du substrat dont les dimensions n'ont pas été altérées.

On obtient un substrat 200 comprenant un substrat support en silicium sur lequel sont disposés des motifs 250 cylindriques de silicium de 10 mm de diamètre et d'épaisseur 205 nm.

### Exemple 4

Sur une plaquette de silicium (substrat poignée 100), un procédé de photolithographie/gravure permet de former des éléments en relief 120 de 10 x 10 mm² et d'une épaisseur de 100 On réalise un détourage du bord de ce substrat 100 à la scie diamantée : d'une largeur de 3 mm et d'une profondeur de 200 La surface de la plaquette 100 est nettoyée par un plasma O₂ suivi d'un nettoyage par voie humide CARO, SC1 de façon à la rendre compatible avec un procédé de collage direct.

Une plaquette (substrat d'intérêt 200) subit une oxydation de façon à former un film 220 de 100 nm d'oxyde à sa surface. Cette plaquette 200 est nettoyée de façon par voie humide de façon à la rendre compatible avec un procédé de collage direct.

On colle directement les deux substrats 100, 200. L'assemblage subit un recuit de 150°C pendant 2h puis est immergé pendant 3 min dans une solution aqueuse de HF à 5 % volumique destinée à graver l'oxyde de silicium. Alternativement, on peut traiter l'empilement en l'exposant à des vapeurs de HF. L'assemblage est ensuite rincé par immersion dans l'eau puis séché par centrifugation.

On démonte le substrat-poignée 100 en insérant un coin dans la structure.

On obtient une plaque d'intérêt 200 de silicium qui présente des motifs 250 cylindriques d'oxyde de silicium de 10 x 5 mm² et d'une épaisseur de 100 nm.

### Exemple 5

Une plaquette de silicium (substrat-poignée 100) est réalisée comme cela est décrit dans l'exemple 1. Elle présente des plots rectangulaires de 10 x 5mm² d'une épaisseur de 15 µm.

Sur une plaquette (substrat d'intérêt 200), on vient déposer 400 nm d'oxyde à partir de TEOS. On dépose ensuite par PVD des couches de Ti, TiN et Cu d'une épaisseur de 10, 50 et 200 nm. Enfin un traitement électrochimique par ECD permet de déposer un film de Cu de 1000 nm. Une étape de polissage du cuivre retire une épaisseur de cuivre de 200 nm et permet de préparer la surface du substrat 200 à un collage direct.

On colle directement les deux substrats 100, 200. L'assemblage est immergé pendant 2 min dans une solution aqueuse 300 de DSP (H₂SO₄/H₂O₂/H₂O en proportion 1/2/50) de façon à graver les couches de cuivre. L'assemblage est ensuite rincé par immersion dans l'eau puis séché par centrifugation.

Cet assemblage est immergé dans une solution SC1 à 70°C pendant 2 min de façon à graver les couches Ti et TiN. L'assemblage est ensuite rincé par immersion dans l'eau puis séché par centrifugation.

On démonte la plaque (substrat poignée 100) en insérant un coin dans la structure.

On obtient une plaque (substrat d'intérêt 200) de silicium qui présente des motifs 250 rectangulaires de cuivre de 10 x 5 mm² d'une épaisseur de 1000 nm.

### Exemple 6

Une plaquette de silicium (substrat poignée 100) est réalisée comme cela est décrit dans l'exemple 1. Elle présente des éléments 120 rectangulaires de 5 x 5mm² d'une épaisseur de 15 µm.

Sur une plaquette (substrat d'intérêt 200), on réalise un damier de plots 230 de cuivre entourés d'une fine couche protectrice de Ti/TiN au sein d'une couche d'oxyde comme présenté en figure 9A. Une barrière de protection 240 en cuivre entoure les zones Z2. Le pas de répétition des plots 230 de cuivre est de 5µm pour des plots 230 carrés de cuivre de 2.5µm de côté. La barrière de cuivre est de 2.5µm de large à la place de deux rangées et colonnes de plots de cuivre. La largueur et longueur extérieure de la barrière ont la même dimension de 5000-3.75-3.75=4992,5µm. Les couches de Ti et TiN font une épaisseur de 10nm et de 50nm. L'épaisseur des plots 230 de cuivre est de 500nm. Ils sont fabriqués suivant un procédé classique de damascène cuivre avec des couches protectrices en Ti/TiN. Un polissage mécano-chimique est réalisé après le procédé damascène de façon à rendre la surface compatible avec un procédé de collage direct hybride.

### On aligne et on colle les deux substrats 100, 200.

Après le collage, l'assemblage subit un recuit de 150°C pendant 2h. L'assemblage est ensuite immergé pendant 3 min dans une solution 300 aqueuse de HF à 5 % volumique destinée à graver l'oxyde de silicium. L'assemblage est ensuite rincé par immersion dans l'eau puis séché par centrifugation. La configuration obtenue est celle de la figure 9B. On peut décoller les deux substrats 100, 200 et on obtient ainsi des zones d'intérêt compatible avec un futur collage direct sur une autre plaque d'intérêt. Il est également possible de ne pas décoller les deux substrats 100, 200 et graver les plots 230 en cuivre non protégés par les éléments en relief 120 et/ou la barrière de protection 240. Pour cela l'assemblage est immergé pendant 2 min dans une solution aqueuse de DSP (H₂SO₄/H₂O₂/H₂O en proportion 1/2/50) de façon à graver le cuivre. L'assemblage est ensuite rincé par immersion dans l'eau puis séché par centrifugation. Cet assemblage est alors est immergé dans une solution SC1 à 70°C pendant 2 min de façon à graver les couches Ti et TiN. L'assemblage est ensuite rincé par immersion dans l'eau puis séché par centrifugation. L'ensemble obtenu correspond à la configuration de la figure 9C. On peut alors décoller les deux substrats 100, 200.

## Revendications

1. Procédé de structuration d'un substrat d'intérêt comprenant les étapes suivantes :
a) coller un substrat-poignée (100) sur un substrat d'intérêt (200), le substrat-poignée (100) comprenant une base (110) et des éléments en relief (120) recouvrant la base (110), le substrat d'intérêt (200) comprenant un substrat support (210) recouvert par une couche mince (220), la couche mince (220) comprenant un matériau sensible à un agent de gravure, moyennant quoi la couche mince (220) comprend des premières zones (Z1) non recouvertes par les éléments en relief (120) et des deuxièmes zones (Z2) recouvertes par les éléments en relief (120),
b) réaliser une gravure avec l'agent de gravure, par voie humide ou gazeuse, pour retirer le matériau sensible à l'agent de gravure présent dans les premières zones (Z1), les deuxièmes zones (Z2) étant protégées lors de la gravure, moyennant quoi la couche mince (220) est structurée sous la forme de motifs (250) en relief,
c) séparer le substrat-poignée (100) du substrat d'intérêt (200).

2. Procédé selon la revendication 1, **caractérisé en ce que** la couche mince (220) comprend un matériau de base, de préférence un oxyde, et plus particulièrement un oxyde de silicium, dans lequel sont disposés des plots (230), de préférence des plots métalliques, et encore plus préférentiellement des plots en cuivre.

3. Procédé selon la revendication 2, **caractérisé en ce que** le matériau sensible à l'agent de gravure est le matériau de base.

4. Procédé selon la revendication 2, **caractérisé en ce que** le matériau sensible à l'agent de gravure correspond aux plots (230).

5. Procédé selon l'une quelconque des revendications précédentes, **caractérisé en ce que** la couche mince (220) comprend des barrières (240), de préférence des barrières (240) métalliques, et plus particulièrement des barrières en cuivre, formant une protection latérale tout autour des deuxièmes zones (Z2).

6. Procédé selon les revendications 4 et 5, **caractérisé en ce que**, lors de l'étape de gravure, les barrières (240) et les plots (230) sont gravés.

7. Procédé selon les revendications 3 et 5, **caractérisé en ce que** le procédé comprend une étape additionnelle entre l'étape b) et l'étape c) au cours de laquelle les barrières (240) et/ou les plots (230) sont gravés.

8. Procédé selon l'une quelconque des revendications précédentes, **caractérisé en ce que** le procédé comprend une étape ultérieure au cours de laquelle le substrat-poignée (100) est utilisé pour structurer un autre substrat d'intérêt.

9. Procédé selon l'une quelconque des revendications précédentes, **caractérisé en ce que**, avant l'étape de collage, le procédé comprend une étape au cours de laquelle, le substrat-poignée (100) est recouvert par une couche de protection à l'agent de gravure du matériau sensible (130, 135).

10. Procédé selon la revendication 9, **caractérisé en ce que** la couche de protection est une couche d'oxyde (135) ou une couche hydrophobe (130), la couche hydrophobe (130) pouvant être formée d'un ou plusieurs composés choisis parmi les silanes, notamment les chlorosilanes, et les polymères comprenant un ou plusieurs halogènes, de préférence les polymères fluorés.

11. Procédé selon l'une quelconque des revendications précédentes, **caractérisé en ce que** le procédé comprend, avant l'étape a), une étape au cours de laquelle le substrat-poignée (100) est fabriqué en formant localement une résine (140) sur un substrat, en gravant le substrat et en retirant la résine (140).

## Patentansprüche

1. Ein Verfahren zum Strukturieren eines Substrats von Interesse, das die folgenden Schritte aufweist:
a) Verbinden eines Handhabungssubstrats (100) mit einem Substrat von Interesse (200), wobei das Handhabungssubstrat (100) eine Basis (110) und erhöhte Elemente (120) aufweist, die die Basis (110) bedecken, wobei das Substrat von Interesse (200) ein Trägersubstrat (210) aufweist, das mit einem dünnen Film (220) bedeckt ist, wobei der dünne Film (220) ein gegenüber einem Ätzmittel empfindliches Material aufweist, wobei der dünne Film (220) erste Bereiche (Z1), die nicht mit den erhabenen Elementen (120) bedeckt sind, und zweite Bereiche (Z2), die mit den erhabenen Elementen (120) bedeckt sind, aufweist,
b) Durchführen eines Nass- oder Gasätzens mit dem Ätzmittel, um das für das Ätzmittel empfindliche Material in den ersten Bereichen (Z1) zu entfernen, wobei die zweiten Bereiche (Z2) während des Ätzens geschützt werden, wodurch der dünne Film (220) in Form von erhabenen Mustern (250) strukturiert wird,
c) Trennen des Handhabungssubstrats (100) vom interessierenden Substrat (200).

2. Das Verfahren gemäß Anspruch 1, wobei der dünne Film (220) ein Grundmaterial, vorzugsweise ein Oxid, insbesondere ein Siliziumoxid, mit darin angeordneten Pads (230), vorzugsweise Metallpads, noch bevorzugter Kupferpads, aufweist.

3. Das Verfahren gemäß Anspruch 2, wobei das gegenüber dem Ätzmittel empfindliche Material das Grundmaterial ist.

4. Das Verfahren gemäß Anspruch 2, wobei das gegenüber dem Ätzmittel empfindliche Material den Pads (230) entspricht.

5. Das Verfahren gemäß einem der vorhergehenden Ansprüche, wobei der dünne Film (220) Barrieren (240), vorzugsweise Metallbarrieren (240) und insbesondere Kupferbarrieren, aufweist, die einen seitlichen Schutz rund um die zweiten Bereiche (Z2) bilden.

6. Das Verfahren gemäß den Ansprüchen 4 und 5, wobei während des Ätzschritts die Barrieren (240) und die Pads (230) geätzt werden.

7. Das Verfahren gemäß den Ansprüchen 3 und 5, wobei das Verfahren einen zusätzlichen Schritt zwischen Schritt b) und Schritt c) aufweist, in dem die Barrieren (240) und/oder die Pads (230) geätzt werden.

8. Das Verfahren gemäß einem der vorhergehenden Ansprüche, wobei das Verfahren einen nachfolgenden Schritt aufweist, in dem das Handhabungssubstrat (100) verwendet wird, um ein anderes Substrat von Interesse zu strukturieren.

9. Das Verfahren gemäß einem der vorhergehenden Ansprüche, wobei das Verfahren vor dem Verbindungsschritt einen Schritt aufweist, in dem das Handhabungssubstrat (100) mit einer Schutzschicht gegen das Ätzmittel des empfindlichen Materials (130, 135) bedeckt wird.

10. Das Verfahren gemäß Anspruch 9, wobei die Schutzschicht eine Oxidschicht (135) oder eine hydrophobe Schicht (130) ist, wobei die hydrophobe Schicht (130) aus einer oder mehreren Verbindungen gebildet sein kann, die aus Silanen, insbesondere Chlorsilanen, und Polymeren, die ein oder mehrere Halogene, vorzugsweise Fluorpolymere, enthalten, ausgewählt sind.

11. Das Verfahren gemäß einem der vorhergehenden Ansprüche, wobei das Verfahren vor Schritt a) einen Schritt aufweist, in dem das Handhabungssubstrat (100) hergestellt wird, indem lokal ein Harz (140) auf einem Substrat gebildet wird, indem das Substrat geätzt wird und indem das Harz (140) entfernt wird.

## Claims

1. Method of structuring a substrate of interest comprising the following steps:
a) bonding a handle substrate (100) to a substrate of interest (200), the handle substrate (100) comprising a base (110) and raised elements (120) covering the base (110), the substrate of interest (200) comprising a support substrate (210) covered by a thin film (220), the thin film (220) comprising a material sensitive to an etchant, whereby the thin film (220) comprises first areas (Z1) not covered with the raised elements (120) and second areas (Z2) covered with the raised elements (120),
b) performing a wet or gaseous etching with the etchant to remove the material sensitive to the etchant present in the first areas (Z1), the second areas (Z2) being protected during the etching, whereby the thin film (220) is structured in the form of raised patterns (250),
c) separating the handle substrate (100) from the substrate of interest (200).

2. Method according to claim 1, wherein the thin film (220) comprises a base material, preferably an oxide, and more particularly a silicon oxide, having pads (230), preferably metal pads, and even more preferably copper pads, arranged therein.

3. Method according to claim 2, wherein the material sensitive to the etchant is the base material.

4. Method according to claim 2, wherein the material sensitive to the etchant corresponds to the pads (230).

5. Method according to one of the preceding claims, wherein the thin film (220) comprises barriers (240), preferably metal barriers (240), and more particularly copper barriers, forming a lateral protection all around the second areas (Z2) .

6. Method according to claims 4 and 5, wherein, during the etch step, the barriers (240) and the pads (230) are etched.

7. Method according to claims 3 and 5, wherein the method comprises an additional step between step b) and step c) during which the barriers (240) and/or the pads (230) are etched.

8. Method according to one of the preceding claims, wherein the method comprises a subsequent step during which the handle substrate (100) is used to structure another substrate of interest.

9. Method according to one of the preceding claims, wherein, prior to the bonding step, the method comprises a step during which the handle substrate (100) is covered with a protective layer against the etchant of the sensitive material (130, 135).

10. Method according to claim 9, wherein the protective layer is an oxide layer (135) or a hydrophobic layer (130), it being possible for the hydrophobic layer (130) to be formed of one or a plurality of compounds selected from among silanes, in particular chlorosilanes, and polymers comprising one or a plurality of halogens, preferably fluoropolymers.

11. Method according to one of the preceding claims, wherein the method comprises, prior to step a), a step during which the handle substrate (100) is manufactured by locally forming a resin (140) on a substrate, by etching the substrate, and by removing the resin (140).
